(19)

**Europäisches Patentamt**
**European Patent Office**
**Office européen des brevets**

(11) **EP 3 362 810 B1**

(12) **EUROPÄISCHE PATENTSCHRIFT**

(45) Veröffentlichungstag und Bekanntmachung des Hinweises auf die Patenterteilung:
**21.08.2019   Patentblatt 2019/34**

(21) Anmeldenummer: **16781705.5**

(22) Anmeldetag: **05.10.2016**

(51) Int Cl.:
*G01R 31/36* (2019.01)          *H01M 10/42* (2006.01)
*H01M 10/48* (2006.01)          *H02J 7/00* (2006.01)
*G01R 31/396* (2019.01)        *G01R 31/3835* (2019.01)
*B60L 58/19* (2019.01)

(86) Internationale Anmeldenummer:
**PCT/EP2016/073706**

(87) Internationale Veröffentlichungsnummer:
**WO 2017/063919 (20.04.2017 Gazette 2017/16)**

(54) **FORTBEWEGUNGSMITTEL, VORRICHTUNG UND VERFAHREN ZUR ERMITTLUNG EINER SPANNUNG EINER ZELLE EINES STRANGS MEHRERER IN REIHE GESCHALTETER ZELLEN EINES ELEKTROCHEMISCHEN ENERGIESPEICHERS**

TRANSPORTATION MEANS, DEVICE AND METHOD FOR DETERMINING A VOLTAGE OF A CELL OF A STRING OF MULTIPLE CELLS CONNECTED IN SERIES OF AN ELECTRO-CHEMICAL ENERGY STORAGE MEANS

MOYEN DE DÉPLACEMENT, DISPOSITIF ET PROCÉDÉ DE DÉTERMINATION D'UNE TENSION D'UNE CELLULE D'UNE CHAÎNE DE PLUSIEURS CELLULES CONNECTÉES EN SÉRIE D'UN ACCUMULATEUR D'ÉNERGIE ÉLECTROCHIMIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.10.2015   DE 102015219828**

(43) Veröffentlichungstag der Anmeldung:
**22.08.2018   Patentblatt 2018/34**

(73) Patentinhaber: **Robert Bosch GmbH**
**70442 Stuttgart (DE)**

(72) Erfinder: **SCHWEIKER, Daniel**
**74399 Walheim (DE)**

(56) Entgegenhaltungen:
**US-A1- 2004 113 586      US-A1- 2010 219 837**
**US-A1- 2013 002 232      US-A1- 2014 015 513**

- **Robert Erickson: "DC-DC POWER CONVERTERS, CHOPPERS, SWITCHING POWER SUPPLIES", , 15. Juni 2007 (2007-06-15), XP055327843, Gefunden im Internet: URL:http://onlinelibrary.wiley.com/store/10.1002/047134608X.W5808.pub2/asset/W5808.pdf?v=1&t=iwhvz3aw&s=7e352b51144a567bfe5588 05d27c9a416d84a3ef [gefunden am 2016-12-09]**
- **BENJAMIN J PATELLA ET AL: "High-Frequency Digital PWM Controller IC for DC-DC Converters", IEEE TRANSACTIONS ON POWER ELECTRONICS, INSTITUTE OF ELECTRICAL AND ELECTRONICS ENGINEERS, USA, Bd. 18, Nr. 1, 1. Januar 2003 (2003-01-01) , Seiten 438-446, XP011078286, ISSN: 0885-8993, DOI: 10.1109/TPEL.2002.807121 [gefunden am 2003-03-20]**
- **Daizhuang Wang ET AL: "Design and Simulation of Gate Driver Circuit Using Pulse Transformer", International Journal of Computer Science Issues (IJCSI), 1. März 2013 (2013-03-01), Seite 305, XP055327846, Mahebourg Gefunden im Internet: URL:http://www.ijcsi.org/papers/IJCSI-10-2-2-305-310.pdf**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 362 810 B1

Printed by Jouve, 75001 PARIS (FR)

**Beschreibung**

Stand der Technik

Die vorliegende Erfindung betrifft ein elektrisch antreibbares Fortbewegungsmittel, eine Vorrichtung zur Spannungsüberwachung einer Zelle eines Strangs mehrerer in Reihe geschalteter Zellen sowie ein Verfahren zur Ermittlung einer Spannung einer Zelle eines Strangs mehrerer in Reihe geschalteter Zellen eines elektrochemischen Energiespeichers. Insbesondere betrifft die vorliegende Erfindung Vereinfachungen der Hardware zur Zellspannungsermittlung.

Elektrochemische Energiespeicher werden zur mobilen Energieversorgung unterschiedlichster Geräte und Einrichtungen verwendet. In Hybrid- und Elektrofahrzeugen werden heutzutage Batterien mit einer hohen Anzahl von Zellen verwendet, um die zum wirtschaftlich und energetisch günstigen Betrieb hohen Spannung bereitstellen zu können. Da die Kapazität der Zellen mit der Alterung zunimmt und überdies einer Exemplarstreuung unterliegt, können die Zellen nur durch Überwachung der Einzelspannung vor Über- oder Tiefentladen geschützt werden. Zur Überwachung der Zellspannungen werden in der Regel Schaltungen mit mehreren Multiplexern und Analog-Digital-Wandlern verwendet. Hierbei werden die Spannungen mehrerer Batteriezellen über einen Multiplexer nacheinander einem Analog-Digital-Wandler zugeführt, der den Analogwert in einen Digitalwert übersetzt. Anschließend werden die so gewandelten Zellspannungen über einen Datenbus an einen Mikrocontroller zur Weiterverarbeitung geschickt. Ein Nachteil dieses Verfahrens besteht in dem relativ hohen Preis geeigneter integrierter Schaltungen. Es ist daher eine Aufgabe der vorliegenden Erfindung, eine alternative Methode zur Erfassung der Einzelspannung bereitzustellen, durch welche die Zellspannungserfassung kostengünstiger wird. US2013/002232 offenbart eine Spannungsmessschaltung für Batteriezellen.

Offenbarung der Erfindung

Die vorstehend identifizierte Aufgabe wird erfindungsgemäß durch ein Verfahren zur Ermittlung einer Spannung einer Zelle eines Strangs mehrerer in Reihe geschalteter Zellen eines elektrochemischen Energiespeichers gelöst. Der elektrochemische Energiespeicher kann beispielsweise eine Traktionsbatterie eines elektrisch antreibbaren Fortbewegungsmittels sein. In einem ersten Schritt wird der Eingang eines Tiefpassfilters (z. B. umfassend einen ohmschen Widerstand R und eine Kapazität C) mit einer Eingangsspannung beaufschlagt, an deren Zustandekommen die betrachtete Zelle zumindest beteiligt ist. Dies erfolgt in einem intermittierenden Verfahren und unter Verwendung eines vorbestimmten Tastverhältnisses. Mit anderen Worten wird die Eingangsspannung insbesondere zur Untersuchung einer einzigen betrachteten Zelle in kurz aufeinanderfolgenden Zeiträumen eingeschaltet und wieder ausgeschaltet. Anschließend wird das Tastverhältnis derart eingestellt, dass die Ausgangsspannung über einem Ausgang des Tiefpassfilters einen vordefinierten Wert erreicht. Nach dem Erreichen des vordefinierten Spannungswertes kann die Spannung der Zelle aus dem eingestellten Tastverhältnis ermittelt werden. Indem die Ausgangsspannung über dem Tiefpass durch eine intermittierende Beaufschlagung des Tiefpasses mit der Eingangsspannung erzeugt wird, kann die vordefinierte Ausgangsspannung unabhängig vom Eingangsspannungspegel stets über einem vergleichsweise empfindlichen Eingang einer Auswerteeinheit (z. B. ein Mikrocontroller) erfasst und ausgewertet werden. Die mitunter hohen Spannungen, welche in einer Traktionsbatterie auftreten können, können erfindungsgemäß vor der Erfassung durch Anpassung des Tastverhältnisses angepasst werden. Mit anderen Worten wird die Dauer der Spannungsbeaufschlagung des Tiefpasses als Indikator für die momentan aktive Zell(-Strang)Spannung verwendet und auf ihrer Basis die Spannung einer interessierenden Zelle ermittelt.

Die Unteransprüche zeigen bevorzugte Weiterbildungen der Erfindung.

Das Ermitteln der Spannung der Zelle aus dem eingestellten Tastverhältnis kann ein Subtrahieren einer Spannung einer zweiten Zelle des Strangs umfassen, welche am Zustandekommen der Eingangsspannung beteiligt ist. Beispielsweise kann die Spannung der zweiten Zelle in einem vorhergehenden Schritt ermittelt worden sein. Insbesondere kann die Spannung der zweiten Zelle ermittelt worden sein, während lediglich eine Zelle des Strangs serieller Zellen aktiv war. Mit anderen Worten war lediglich eine einzelne Zelle an den Eingang des Tiefpassfilters angeschlossen. Auf diese Weise kann bei einer nachfolgenden erfindungsgemäßen Ermittlung einer Teilstrangspannung umfassend zwei oder mehr Zellen, die Spannung der zweiten Zelle bereits als bekannt vorausgesetzt und von der ermittelten Teilstrangspannung abgezogen werden, um die Einzelzellspannung einer weiteren, an der Eingangsspannung beteiligten Zelle zu bestimmen. Auf diese Weise kann in einem iterativen Verfahren die Spannung einer jeden Zelle des Strangs des elektrochemischen Energiespeichers ermittelt werden.

Zwischen zwei jeweils aufeinanderfolgenden Zeiträumen, in welchen der Eingang des Tiefpassfilters beaufschlagt wird, kann der Eingang des Tiefpassfilters kurzgeschlossen werden, um eine auf dem Kondensator des Tiefpassfilters verbliebene Spannung über den Widerstand des Tiefpassfilters abzubauen. Auf diese Weise kann eine jede Messung von einem identischen Zustand ausgehend begonnen werden. Messungen können zur Überprüfung erhaltener Ergebnisse automatisch wiederholt werden, bevor eine weitere Zelle dem gemessenen Strang hinzugeschaltet wird. Alternativ ist es möglich, lediglich einen einzelnen Beaufschlagungszeitraum zu verwenden, um eine gegebene Zellanordnung (Teilstrang) hinsichtlich der anliegenden Spannung zu überprüfen.

Gemäß einem zweiten Aspekt der vorliegenden Erfindung wird eine Vorrichtung zur Spannungsüberwachung einer Zelle eines Strangs mehrerer in Reihe geschalteter Zellen eines elektrochemischen Energiespeichers vorgeschlagen. Die Vorrichtung umfasst eine Vielzahl elektrischer, galvanisch in Reihe miteinander verbundener Eingangstore mit jeweils einem ersten Anschluss und einem zweiten Anschluss. Hierbei ist aufgrund der Reihenschaltung der erste Anschluss eines ersten Eingangstores mit einem zweiten Anschluss eines benachbarten Eingangstores elektrisch identisch. Auch die Vorrichtung weist eine erste Vielzahl elektrischer Schalter auf. Ein zweiter elektrischer Schalter und ein dritter elektrischer Schalter sind zusätzlich vorgesehen, um den Eingang eines ebenfalls enthaltenen Tiefpassfilters mit den Eingangstoren zu verbinden bzw. den Eingang des Tiefpassfilters kurzzuschließen. Für den Betrieb der Schaltung gemäß dem vorstehend beschriebenen Verfahren sind weiter eine Ansteuereinheit und eine Auswerteeinheit vorgesehen. Jeder der ersten Vielzahl elektrischer Schalter ist eingerichtet, einen anderen zweiten Anschluss der Eingangstore mit einem elektrischen Knotenpunkt zu verbinden. Insbesondere ein einem niedrigen elektrischen Potential zugeordneter Anschluss eines auf einem niedrigen Spannungspegel operierenden Eingangstores ist ohne einen elektrischen Schalter mit dem Eingang des Tiefpasses (z. B. einem Niederpotentialeingang bzw. einer elektrischen Masse) dauerhaft verbunden. Der zweite elektrische Schalter ist eingerichtet, den Knotenpunkt mit dem Tiefpassfilter zu ersten Zeitpunkten getaktet zu verbinden. Der dritte elektrische Schalter ist eingerichtet, den Eingang des Tiefpassfilters zu zweiten Zeitpunkten (welche sich abseits der ersten Zeitpunkte bzw. zwischen den ersten Zeitpunkten befinden) getaktet kurzzuschließen. Mit anderen Worten ist der dritte Schalter eingerichtet, eine Kapazität des Tiefpassfilters über den Widerstand des Tiefpassfilters zu entladen. Die Ansteuereinheit ist eingerichtet, einen Eingang des Tiefpassfilters über den zweiten elektrischen Schalter mit einer Spannung, an deren Zustandekommen die Zelle zumindest beteiligt ist, intermittierend beaufschlagt. Das Tastverhältnis wird, wie dies in Verbindung mit dem erfindungsgemäßen Verfahren beschrieben worden ist, derart eingestellt, dass sich eine vordefinierte Ausgangsspannung für den Tiefpassfilter ergibt. Die Auswerteeinheit ist entsprechend eingerichtet, das Tastverhältnis derart einzustellen, dass die Ausgangsspannung über einem Ausgang des Tiefpassfilters den vordefinierten Wert erreicht. Hierzu kann der Ausgang des Tiefpassfilters mit einer Auswerteeinheit (optional umfassend einen Analog-Digital-Wandler) elektrisch verbunden sein. Meldet die Auswerteeinheit eine gegenüber dem vordefinierten Wert geringere Spannung, wird das Tastverhältnis zugunsten der EIN-Zeiten verändert, bis der vordefinierte Wert erreicht wird. Ist die Ausgangsspannung des Tiefpassfilters höher als der vordefinierte Wert, wird das Tastverhältnis zugunsten der AUS-Zeiten angepasst, bis die Ausgangsspannung des Tiefpassfilters auf den vordefinierten Wert abgesunken ist. Aus dem derart eingestellten Tastverhältnis wird die Spannung der Zelle ermittelt. Da die vordefinierte Spannung ebenso wie die Kenngrößen des Widerstandes und der Kapazität des Tiefpasses der Auswerteeinheit bekannt sind, kann in für den Fachmann einfacher Weise auf die über dem dritten Schalter anliegende Spannung (identisch mit der Eingangsspannung des Tiefpasses) geschlossen werden. In Abhängigkeit der über dem Eingang des Tiefpassfilters anliegenden Zellspannungen kann - wie in Verbindung mit dem erfindungsgemäßen Verfahren beschrieben - iterativ eine jede Klemmenspannung einer jeden Zelle bestimmt werden.

Die Auswerteeinheit kann einen Analog-Digital-Wandler aufweisen, welcher die ermittelten Ausgangsspannungen des Tiefpassfilters einem Mikrocontroller zuführt, der wiederum beispielsweise für die Ausführung der Schritte des erfindungsgemäßen Verfahrens verantwortlich sein kann. Insbesondere kann der Mikrocontroller die Tastverhältnisse des zweiten Schalters und des dritten Schalters ermitteln bzw. festlegen und durch Ansteuern der ersten Vielzahl elektrischer Schalter den gewählten Teilstrang elektrisch mit dem Eingang des Tiefpassfilters verbinden. Weiter kann die Auswerteeinheit einen programmierbaren Prozessor (z. B. einen Mikrocontroller, einen FPGA, ein elektronisches Steuergerät o. ä.) umfassen. Dieser kann auch Informationen von anderen Strängen und Teilsträngen desselben Energiespeichers und/oder anderer Energiespeicher erhalten und auswerten. Auch diese Informationen können mittels einer erfindungsgemäßen Vorrichtung bzw. eines erfindungsgemäßen Verfahrens ermittelt worden sein.

Auch die Ansteuereinheit kann einen programmierbaren Prozessor aufweisen, welcher z.B. als Mikrocontroller, Nanocontroller, FPGA oder elektronisches Steuergerät ausgestaltet ist. Die Ansteuereinheit kann insbesondere Teile der Auswerteeinheit umfassen, oder anders herum.

Optional kann die Vorrichtung weiter eine Vielzahl elektrischer Widerstände aufweisen, von welchen jeweils einer zwischen den zweiten Anschlüssen der Eingangstore und dem elektrischen Knotenpunkt angeordnet ist. Insbesondere der erste Anschluss des dem niedrigsten elektrischen Potential zugeordneten Eingangstors kann ohne einen elektrischen Widerstand der besagten Vielzahl elektrischer Widerstände ausgestaltet sein. Die Vielzahl elektrischer Widerstände kann zwischen den Eingangstoren und dem jeweiligen elektrischen Schalter der Vielzahl elektrischer Schalter und/oder zwischen dem elektrischen Schalter der Vielzahl elektrischer Schalter und dem Knotenpunkt angeordnet ist. Mittels dieser Widerstände kann ein Ladungsausgleich zwischen den Zellen vorgenommen werden, der auch als "Balancing" bezeichnet wird.

Gemäß einem dritten Aspekt der vorliegenden Erfindung wird ein elektrisch antreibbares Fortbewegungsmittel vorgeschlagen, welches eine Vorrichtung gemäß dem zweitgenannten Erfindungsaspekt umfasst. Das elektrisch antreibbare Fortbewegungsmittel kann als elektrisch antreibbares Fahrrad oder als elektrisch antreibbarer Pkw ausgestaltet sein. Entsprechend ergeben sich die Merkmale, Merkmalskombinationen und die sich aus diesen ergebenden Vorteile des Fortbewegungsmittels entsprechend dem in Verbindung mit dem erfindungsgemäßen Verfahren und der erfindungsgemäßen Vorrichtung gemachten Ausführungen entsprechend.

Kurze Beschreibung der Zeichnungen

Nachfolgend werden Ausführungsbeispiele der Erfindung unter Bezugnahme auf die begleitenden Zeichnungen im Detail beschrieben. In den Zeichnungen ist:

Figur 1    eine schematische Darstellung eines Ausführungsbeispiels eines erfindungsgemäß ausgestalteten Fortbewegungsmittels;

Figur 2    ein Prinzipschaltbild einer im Stand der Technik zur Zellspannungsermittlung verwendeten Architektur;

Figur 3    ein Prinzipschaltbild eines ersten Ausführungsbeispiels einer erfindungsgemäßen Vorrichtung; und

Figur 4    ein Flussdiagramm veranschaulichend Schritte eines Ausführungsbeispiels eines erfindungsgemäßen Verfahrens zur Ermittlung einer Spannung einer Zelle eines Strangs mehrerer in Reihe geschalteter Zellen.

Ausführungsformen der Erfindung

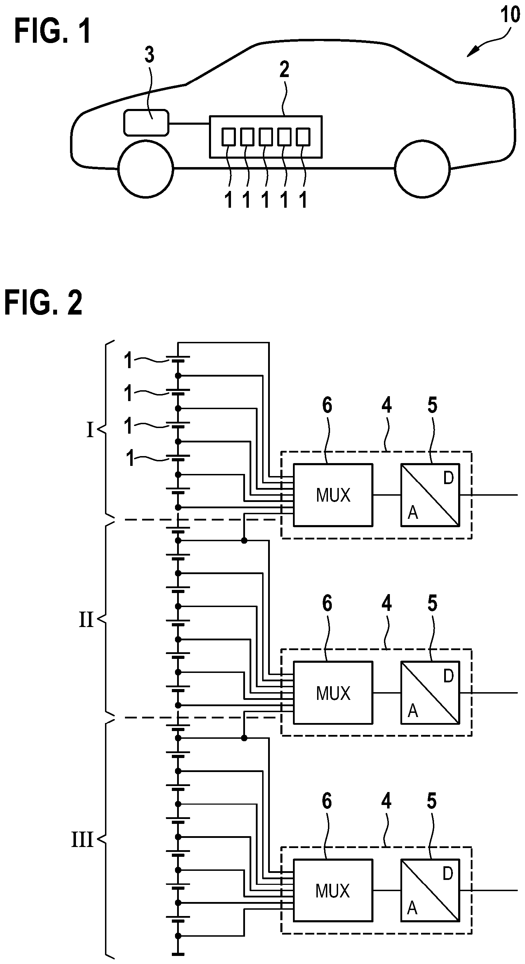

Figur 1 zeigt einen Pkw 10 als erfindungsgemäß ausgestaltetes Fortbewegungsmittel, welches über eine elektrische Antriebsmaschine 3 und einen diese speisenden elektrochemischen Energiespeicher 2 mit einer Vielzahl Zellen 1 als Antriebsstrang verfügt. Zur Ermittlung der Spannung der Zellen 1 wird im Stand der Technik häufig eine Schaltung gemäß Figur 2 verwendet.

Figur 2 zeigt einen Strang I von Zellen 1, welcher gruppenweise durch eine Auswerteeinheit 4 umfassend einen Multiplexer 6 und einen Analog-Digital-Wandler 5 überwacht wird. Hierbei werden nacheinander mehrere Batteriezellspannungen über den Multiplexer 6 dem Analog-Digital-Wandler 5 zugeführt, welcher den Analogwert der Zellspannung in einen Digitalwert übersetzt. Anschließend werden die so ermittelten Zellspannungen über einen Datenbus 12 von einem Mikrocontroller (nicht dargestellt) zur Weiterverarbeitung geschickt. Aufgrund der erforderlichen integrierten Schaltungen ist die dargestellte Architektur relativ kostenintensiv.

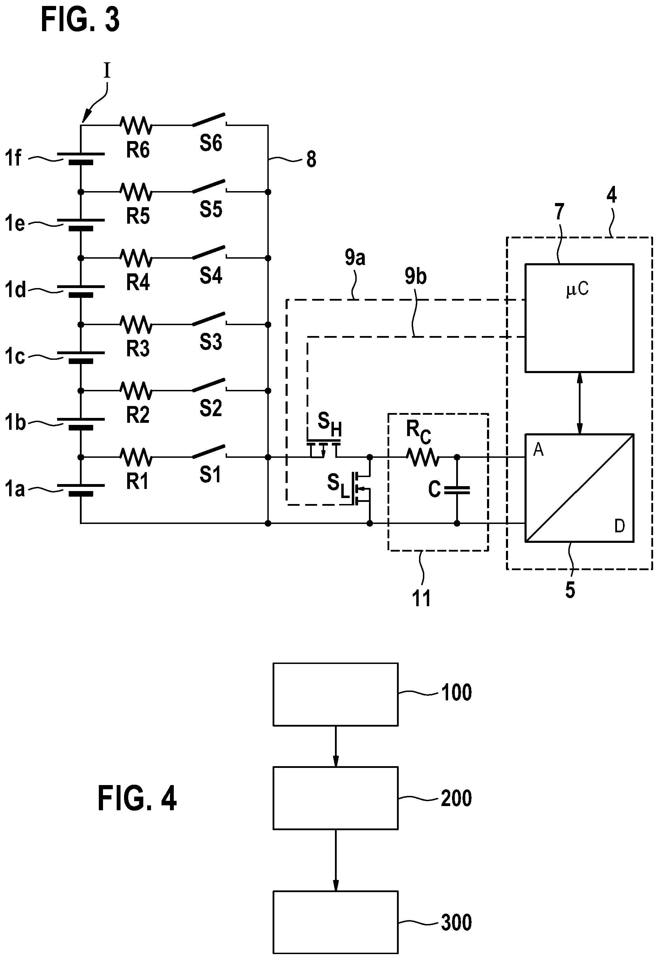

Figur 3 zeigt ein Prinzipschaltbild eines Ausführungsbeispiels einer erfindungsgemäßen Vorrichtung zur Spannungsüberwachung einer Zelle 1b, eines Strangs I mehrerer in Reihe geschalteter Zellen 1a, 1b, 1c, 1d, 1e, 1f eines elektrochemischen Energiespeichers (Bezugszeichen 2 in Figur 1). Die Zellen 1a bis 1f sind elektrisch mit den Anschlüssen jeweiliger Eingangstore verbunden, deren jeweiliger zweiter Anschluss über einen ohmschen Widerstand R1, R2, R3, R4, R5, R6 und einen in Reihe zu diesen geschalteten Schalter S1, S2, S3, S4, S5, S6 mit einem elektrischen Knotenpunkt 8 verbunden ist. Der elektrische Knotenpunkt 8 ist über einen MOSFET $S_H$ als zweiter Schalter mit dem Eingang eines Tiefpassfilters 11 umfassend einen ohmschen Widerstand $R_C$ und eine parallel zum Ausgang liegenden Kondensator C verbunden. Zwischen dem MOSFET $S_H$ und dem Widerstand $R_C$ ist ein zweiter MOSFET $S_L$ als dritter Schalter angeschlossen und eingerichtet, im Ansprechen auf ein Steuersignal über eine Steuerleitung 9a durch einen Mikrocontroller 7 einer Auswerteeinheit 4 den Eingang des Tiefpassfilters 11 kurzuschließen. Derselbe Mikrocontroller 7 ist eingerichtet, über eine Steuerleitung 9b ein getaktetes Signal zur getakteten Schaltung des MOSFETs $S_H$ zu senden, der in Abhängigkeit der aktuell zum Laden der Kapazität C verwendeten Zellen 1a bis 1f länger oder kürzer eingeschaltet sein muss, um am Eingang des Analog-Digital-Wandlers 5 der Auswerteeinheit 4 eine über den Mikrocontroller 7 vordefinierte Spannung zu erzeugen. Die Ansteuerung der MOSFETs $S_L$, $S_H$ kann alternativ oder zusätzlich über eine (nicht dargestellte) Gate-Unit ("Gate-Treiber") erfolgen, die unter der Kontrolle des Mikrocontrollers 7 steht. Mit dem dargestellten Messkonzept wird an jedem Zellabgriff ein Widerstand R1 bis R6 angebracht, welcher über einen Schalter S1 bis S6 an einen Knotenpunkt 8 geführt wird. Über den MOSFET $S_L$ kann der Eingang des Tiefpasses 11 mit der elektrischen Masse verbunden werden. Mittels des Mikrocontrollers 7 wird das Tastverhältnis der beiden MOSFETs $S_H$ und $S_L$ derart angepasst, dass eine definierte Spannung am Analog-Digital-Wandler 5 gewandelt und vom Mikrocontroller 7 erfasst wird. Aus dem verwendeten Tastverhältnis und den aktuell gemessenen sowie zuvor ermittelten Einzelzellspannungen kann auf die aktuelle Zellspannung geschlossen werden. Mit den ohmschen Widerständen R1 bis R6 in jedem Anschlusszweig bzw. Kanal der Vorrichtung kann durch simultanes Schließen von zwei benachbarten Schaltern S1 bis S6 die eingeschlossene Zelle 1a bis 1f entladen bzw. der Strang "gebalanced" werden.

Figur 4 zeigt Schritte eines Ausführungsbeispiels eines erfindungsgemäßen Verfahrens zur Ermittlung einer Spannung einer Zelle. In Schritt 100 wird ein Eingang eines Tiefpassfilters mit einer Eingangsspannung beaufschlagt, an deren Zustandekommen die Zelle zumindest beteiligt ist. Mit anderen Worten ist die Zelle, welche hinsichtlich ihrer aktuellen Klemmenspannung untersucht werden soll, zumindest ein Teil derjenigen Zellen, welche derzeit elektrisch an den Eingang des Tiefpassfilters angeschlossen sind. Die Beaufschlagung des Tiefpassfilters mit der Eingangsspannung erfolgt mit einem Tastverhältnis, welches in Schritt 200 derart eingestellt wird, dass die Ausgangsspannung über einem Ausgang des Tiefpassfilters einen vordefinierten Wert erreicht. Hierzu kann das Tastverhältnis geregelt werden, bis die Ausgangsspannung dem vordefinierten Wert entspricht oder einen vordefinierten Toleranzbereich trifft. Anschließend wird in Schritt 300 aus dem eingestellten Tastverhältnis die Spannung der fraglichen Zelle ermittelt. Hierbei wird, sofern nicht lediglich eine einzelne Zelle dem Eingang des Tiefpassfilters hinzugeschaltet war, jede bereits bekannte Spannung enthaltener Zellen von einem ermittelten Spannungswert subtrahiert. Mit anderen Worten ergibt sich die Spannung der fraglichen Zelle als Differenz der ermittelten Spannung abzüglich sämtlicher, bereits zuvor (z. B. erfindungsgemäß) ermittelter Zellspannungen des derzeit aktiven Teilstrangs.

Die vorliegende Erfindung ermöglicht eine Ermittlung der Spannung mehrerer in Serie geschalteter Zellen anhand des Tastverhältnisses einer Pulsweitenmodulation (PWM)-Regelung. Es wird dabei immer das Potential des Spannungsabgriffs ermittelt. Startend von der niedrigsten Zelle kann somit jede Einzelzellspannung ermittelt werden. Dazu wird ein Filter genutzt, welcher aus einer der im Pack enthaltenen Zellen gespeist wird. Es wird angestrebt, eine definierte Zielspannung am Messeingang der Auswerteeinheit bzw. des Analog-Digital-Wandlers zu erreichen. Diese Zielspannung ermöglicht eine bestmögliche Aussteuerung und somit eine bestmögliche Empfindlichkeit des ADCs. Diese Zielspannung wird über die Auswerteeinheit (z. B. ein Mikrocontroller) geregelt. Das resultierende Tastverhältnis lässt auf die Spannung des Abgriffs folgern:

$$D_n = \frac{U_{AD}}{\sum_{i=1}^{n} U_{Ci}}$$

Während die Figuren der vorliegenden Beschreibung jeweils sechs Zellen bzw. Eingangstore aufweisen, ist dem Fachmann ersichtlich, dass sich das erfindungsgemäße Verfahren sowie die erfindungsgemäße Vorrichtung auf eine beliebige Anzahl in Reihe geschalteter Zellen erweitern bzw. beschränken lassen.

Die vorliegende Erfindung ermöglicht eine kostengünstige, da bauteilsparende, Anordnung, bei welcher die Messung der Zellspannungen unabhängig von Bauteilparametern erfolgen kann. Überdies wird optional eine integrierte Architektur für einen Ladungsausgleich bzw. ein Zellbalancing vorgeschlagen. Vorteilhaft für die Ergebnisse mittels der vorliegenden Erfindung ist eine hohe Auflösung des PWM-Kanals, welcher über die zweite Steuerleitung den zweiten elektrischen Schalter (im Beispiel nach Figur 3 der MOSFET $S_H$) ansteuert.

## Patentansprüche

1. Verfahren zur Ermittlung einer Spannung einer Zelle (1b) eines Strangs (I) mehrerer in Reihe geschalteter Zellen (1a, 1b, 1c, 1d, 1e, 1f) eines elektrochemischen Energiespeichers (2), **dadurch gekennzeichnet, dass** das Verfahren die folgenden Schritte umfasst:

   - Beaufschlagen (100) eines Eingangs eines Tiefpassfilters (11) mit einer Eingangsspannung, an deren Zustandekommen die Zelle (1b) zumindest beteiligt ist, in einem Tastverhältnis,
   - Einstellen (200) des Tastverhältnisses derart, dass die Ausgangsspannung über einem Ausgang des Tiefpassfilters (11) einen vordefinierten Wert erreicht, und
   - Ermitteln (300) der Spannung der Zelle (1b) aus dem eingestellten Tastverhältnis.

2. Verfahren nach Anspruch 1, wobei das

   - Ermitteln (300) der Spannung der Zelle (1b) aus dem eingestellten Tastverhältnis ein Subtrahieren einer Spannung einer zweiten Zelle (1a) des Strangs (I) umfasst, welche am Zustandekommen der Eingangsspannung beteiligt ist.

3. Verfahren nach Anspruch 1 oder 2, wobei zwischen jeweils zwei aufeinanderfolgenden Zeiträumen des Beaufschlagens der Eingang des Tiefpassfilters (11) kurzgeschlossen wird.

4. Vorrichtung zur Spannungsüberwachung einer Zelle (1b) eines Strangs (I) mehrerer in Reihe geschalteter Zellen (1a, 1b, 1c, 1d, 1e, 1f) eines elektrochemischen Energiespeichers (2) umfassend:

   - eine Vielzahl elektrischer, galvanisch in Reihe miteinander verbundener Eingangstore mit jeweils einem ersten Anschluss und einem zweiten Anschluss,
   - eine erste Vielzahl elektrischer Schalter (S1-S6),
   - eine Ansteuereinheit (7) und
   - eine Auswerteeinheit (4), wobei
   - jeder der ersten Vielzahl elektrischer Schalter (S1-S6) eingerichtet ist, einen anderen zweiten Anschluss der Eingangstore mit einem elektrischen Knotenpunkt (8) zu verbinden,

   **dadurch gekennzeichnet, dass** die Vorrichtung weiterhin umfasst:

   - einen zweiten elektrischen Schalter ($S_H$),

- einen dritten elektrischen Schalter ($S_L$) und
- ein Tiefpassfilter (11), wobei
- der zweite elektrische Schalter ($S_H$) eingerichtet ist, den Knotenpunkt mit dem Tiefpassfilter (11) zu ersten Zeitpunkten getaktet zu verbinden,
- der dritte elektrische Schalter ($S_L$) eingerichtet ist, den Eingang des Tiefpassfilters (11) zu zweiten Zeitpunkten getaktet kurzzuschließen,
- und die Ansteuereinheit (7) eingerichtet ist, einen Eingang des Tiefpassfilters (11) über den zweiten elektrischen Schalter ($S_H$) mit einer Spannung, an deren Zustandekommen die Zelle (1b) zumindest beteiligt ist, in einem Tastverhältnis zu beaufschlagen, und
- die Auswerteeinheit (4) eingerichtet ist,

    - das Tastverhältnis derart einzustellen, dass die Ausgangsspannung über einem Ausgang des Tiefpassfilters (11) einen vordefinierten Wert erreicht, und
    - aus dem eingestellten Tastverhältnis die Spannung der Zelle (1b) zu ermitteln.

**5.** Vorrichtung nach Anspruch 4, wobei die Auswerteeinheit (4) eingerichtet ist,

    - die Spannung der Zelle (1b) aus dem eingestellten Tastverhältnis zu ermitteln, indem sie eine Spannung einer zweiten Zelle (1a) des Strangs (I), welche am Zustandekommen der Eingangsspannung beteiligt ist, subtrahiert.

**6.** Vorrichtung nach Anspruch 4 oder 5, wobei die Auswerteeinheit (4) eingerichtet ist,

    - die Spannung der zweiten Zelle (1a) zu ermitteln,
    - eine Spannung einer Reihenschaltung von Zellen (1a, 1b) des Strangs zu ermitteln und
    - die Spannung der zweiten Zelle (1a) von der Spannung der Reihenschaltung von Zellen (1a, 1b) des Strangs (I) zu subtrahieren.

**7.** Vorrichtung nach Anspruch 4, 5 oder 6, wobei

    - die Auswerteeinheit (4) eingerichtet ist, zwischen jeweils zwei aufeinanderfolgenden Zeiträumen des Beaufschlagens den Eingang des Tiefpassfilters (11) kurzzuschließen.

**8.** Vorrichtung nach einem der Ansprüche 4 bis 7, wobei die Auswerteeinheit (4)

    - einen Analog/Digital-Wandler (5) und/oder
    - einen programmierbaren Prozessor, insbesondere einen Mikrocontroller, umfasst.

**9.** Vorrichtung nach einem der Ansprüche 4 bis 8, wobei die Ansteuereinheit (7)

    - einen programmierbaren Prozessor, insbesondere einen Mikrocontroller, und/oder
    - eine Gate-Unit, auch "Gate-Treiber" genannt,

umfasst.

**10.** Vorrichtung nach einem der Ansprüche 4 bis 9, weiter umfassend

    - eine Vielzahl elektrischer Widerstände (R1-R6), von welchen jeweils einer zwischen den zweiten Anschlüssen der Eingangstore und dem elektrischen Knotenpunkt (8) angeordnet ist.

**11.** Elektrisch antreibbares Fortbewegungsmittel (10) umfassend

    - eine Vorrichtung nach einem der vorstehenden Ansprüche 4 bis 10.

## Claims

**1.** Method for identifying a voltage of a cell (1b) of a string (I) of a plurality of series-connected cells (1a, 1b, 1c, 1d, 1e, 1f) of an electrochemical energy store (2),
**characterized in that**
the method comprises the following steps:

    - applying (100) an input voltage to an input of a low-pass filter (11) at a duty cycle, the cell (1b) being at least involved in the establishment of said input voltage,
    - adjusting (200) the duty cycle in such a way that the output voltage across an output of the low-pass filter (11) reaches a predefined value, and
    - identifying (300) the voltage of the cell (1b) from the adjusted duty cycle.

**2.** Method according to Claim 1, wherein the

    - identification (300) of the voltage of the cell (1b) from the adjusted duty cycle comprises subtraction of a voltage of a second cell (1a) of the string (I), said second cell being involved in the establishment of the input voltage.

**3.** Method according to Claim 1 or 2, wherein the input of the low-pass filter (11) is short-circuited between two respectively successive periods of the application.

4. Apparatus for monitoring the voltage of a cell (1b) of a string (I) of a plurality of series-connected cells (1a, 1b, 1c, 1d, 1e, 1f) of an electrochemical energy store (2), comprising:

- a multiplicity of electrical input ports, which are connected to one another galvanically in series and each have a first connection and a second connection,
- a first multiplicity of electrical switches (S1-S6),
- an actuation unit (7) and
- an evaluation unit (4), wherein
- each of the first multiplicity of electrical switches (S1-S6) is configured to connect a different second connection of the input ports to an electrical node (8),

**characterized in that**
the apparatus further comprises:

- a second electrical switch ($S_H$),
- a third electrical switch ($S_L$) and
- a low-pass filter (11), wherein
- the second electrical switch ($S_H$) is configured to connect the node to the low-pass filter (11) at first times in a clocked manner,
- the third electrical switch ($S_L$) is configured to short-circuit the input of the low-pass filter (11) at second times in a clocked manner,
- and the actuation unit (7) is configured to apply a voltage to an input of the low-pass filter (11) via the second electrical switch ($S_H$) at a duty cycle, the cell (1b) being at least involved in the establishment of said voltage, and
- the evaluation unit (4) is configured

- to adjust the duty cycle in such a way that the output voltage across an output of the low-pass filter (11) reaches a predefined value, and
- to identify the voltage of the cell (1b) from the adjusted duty cycle.

5. Apparatus according to Claim 4, wherein the evaluation unit (4) is configured

- to identify the voltage of the cell (1b) from the adjusted duty cycle by virtue of said evaluation unit subtracting a voltage of a second cell (1a) of the string (I), said second cell being involved in the establishment of the input voltage.

6. Apparatus according to Claim 4 or 5, wherein the evaluation unit (4) is configured

- to identify the voltage of the second cell (1a),
- to identify a voltage of a series circuit of cells (1a, 1b) of the string and

- to subtract the voltage of the second cell (1a) from the voltage of the series circuit of cells (1a, 1b) of the string (I).

7. Apparatus according to Claim 4, 5 or 6, wherein

- the evaluation unit (4) is configured to short-circuit the input of the low-pass filter (11) between two respectively successive periods of the application.

8. Apparatus according to one of Claims 4 to 7, wherein the evaluation unit (4) comprises

- an analogue-to-digital converter (5) and/or
- a programmable processor, in particular a microcontroller.

9. Apparatus according to one of Claims 4 to 8, wherein the actuation unit (7) comprises

- a programmable processor, in particular a microcontroller, and/or
- a gate unit, also referred to as "gate driver".

10. Apparatus according to one of Claims 4 to 9, further comprising

- a multiplicity of electrical resistors (R1-R6), each of which is arranged between the second connections of the input ports and the electrical node (8).

11. Electrically driveable transport means (10) comprising

- an apparatus according to one of the preceding Claims 4 to 10.

**Revendications**

1. Procédé de détermination d'une tension d'une cellule (1b) d'une chaîne (I) de plusieurs cellules (1a, 1b, 1c, 1d, 1e, 1f) branchées en série d'un accumulateur d'énergie (2) électrochimique,
**caractérisé en ce que**
le procédé comprend les étapes suivantes :

- sollicitation (100) d'une entrée d'un filtre passe-bas (11) avec une tension d'entrée à l'obtention de laquelle participe au moins la cellule (1b), en un rapport cyclique,
- réglage (200) du rapport cyclique de telle sorte que la tension de sortie sur une sortie du filtre passe-bas (11) atteint une valeur prédéfinie et
- détermination (300) de la tension de la cellule (1b) à partir du rapport cyclique réglé.

**2.** Procédé selon la revendication 1, la détermination (300) de la tension de la cellule (1b) à partir du rapport cyclique réglé comprenant une soustraction d'une tension d'une deuxième cellule (1a) de la branche (I), laquelle participe à l'obtention de la tension d'entrée.

**3.** Procédé selon la revendication 1 ou 2, l'entrée du filtre passe-bas (11) étant court-circuitée entre deux périodes respectivement successives de la sollicitation.

**4.** Dispositif de surveillance de la tension d'une cellule (1b) d'une chaîne (I) de plusieurs cellules (1a, 1b, 1c, 1d, 1e, 1f) branchées en série d'un accumulateur d'énergie (2) électrochimique, comprenant :

   - une pluralité de portes d'entrée électriques reliées galvaniquement en série les unes aux autres, comprenant respectivement une première borne et une deuxième borne,
   - une première pluralité de commutateurs électriques (S1-S6),
   - une unité de commande (7) et
   - une unité d'interprétation (4),
   - chacun de la première pluralité de commutateurs électriques (S1-S6) étant conçu pour relier une autre deuxième borne des portes d'entrée à un point nodal électrique (8),

   **caractérisé en ce que**
   le dispositif comprend en outre :

   - un deuxième commutateur électrique ($S_H$),
   - un troisième commutateur électrique ($S_L$) et
   - un filtre passe-bas (11)
   - le deuxième commutateur électrique ($S_H$) étant conçu pour relier le point nodal au filtre passe-bas (11) de manière cyclique à des premiers instants,
   - le troisième commutateur électrique ($S_L$) étant conçu pour court-circuiter l'entrée du filtre passe-bas (11) de manière cyclique à des deuxièmes instants,
   - et l'unité de commande (7) étant conçue pour solliciter, en un rapport cyclique, une entrée du filtre passe-bas (11) par le biais du deuxième commutateur électrique ($S_H$) avec une tension à l'obtention de laquelle participe au moins la cellule (1b), et
   - l'unité d'interprétation (4) étant conçue pour

      - régler le rapport cyclique de telle sorte que la tension de sortie sur une sortie du filtre passe-bas (11) atteint une valeur prédéfinie, et
      - déterminer la tension de la cellule (1b) à partir du rapport cyclique réglé.

**5.** Dispositif selon la revendication 4, l'unité d'interprétation (4) étant conçue pour

   - déterminer la tension de la cellule (1b) à partir du rapport cyclique réglé en soustrayant une tension d'une deuxième cellule (1a) de la branche (I), laquelle participe à l'obtention de la tension d'entrée.

**6.** Dispositif selon la revendication 4 ou 5, l'unité d'interprétation (4) étant conçue pour

   - déterminer la tension de la deuxième cellule (la),
   - déterminer une tension d'un circuit série de cellules (1a, 1b) de la branche, et
   - soustraire la tension de la deuxième cellule (1a) de la tension du circuit série de cellules (1a, 1b) de la branche (I).

**7.** Dispositif selon la revendication 4, 5 ou 6,

   - l'unité d'interprétation (4) étant conçue pour court-circuiter l'entrée du filtre passe-bas (11) entre deux périodes respectivement successives de la sollicitation.

**8.** Dispositif selon l'une des revendications 4 à 7, l'unité d'interprétation (4) comprenant

   - un convertisseur analogique/numérique (5) et/ou
   - un processeur programmable, notamment un microcontrôleur.

**9.** Dispositif selon l'une des revendications 4 à 8, l'unité de commande (7) comprenant

   - un processeur programmable, notamment un microcontrôleur, et/ou
   - une unité à porte, également appelée circuit d'attaque de porte.

**10.** Dispositif selon l'une des revendications 4 à 9, comprenant en outre une pluralité de résistances électriques (R1-R6), parmi lesquelles l'une est respectivement disposée entre les deuxièmes bornes des portes d'entrée et le point nodal (8) électrique.

**11.** Moyen de transport (10) à propulsion électrique, comprenant

   - un dispositif selon l'une des revendications 4 à 10.

# FIG. 1

# FIG. 2

## FIG. 3

## FIG. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2013002232 A